# EUROPEAN PATENT APPLICATION

(11) **EP 3 124 241 A1**
(43) Date of publication of application: **01.02.2017**
(21) Application number: 15767842.6
(22) Date of filing: 27.03.2015
(51) Int. Cl.: B32B 27/36, B32B 5/18, B32B 27/00, C09J 7/02, H01L 23/373, H05K 7/20

(54) **HEAT-CONDUCTING LAMINATE FOR ELECTRONIC DEVICE**

(30) Priority: 28.03.2014 JP 2014069989
(71) Applicant: Sekisui Chemical Co., Ltd., Osaka-shi, Osaka 530-8565 (JP)
(72) Inventor: KATO, Tetsuhiro, Hasuda-shi Saitama 349-0198 (JP); SHIMONISHI, Koji, Hasuda-shi Saitama 349-0198 (JP)
(74) Representative: Merkle, Gebhard
(86) International application number: PCT/JP2015/059589
(87) International publication number: WO 2015/147254

(57) **Abstract**

A thermal conductive laminate for electronic equipment produced by attaching a two-sided adhesive tape to at least one surface of a foam sheet having a 25% compressive strength of 200 kPa or less and a thickness of 0.05 to 1.0 mm, in which the two-sided adhesive tape has a substrate formed of polyethylene terephthalate having a thickness of 2 to 100 µm.

## Description

### Technical Field

The present invention relates to a thermal conductive laminate for electronic equipment for effectively dissipating the interior heat of electronic equipment to the exterior.

### Background Art

In electronic equipment such as smartphones requiring a reduction in size, electronic parts are highly densely integrated and generate a large amount of heat. Since such heat causes a malfunction, a heat sink material is provided for dissipating the heat to the exterior of the equipment. As the heat sink material, which is generally provided between electronic parts serving as a heat generator and a metal housing, e.g., heat dissipation grease and heat dissipation gel, which highly accurately follow a concavo-convex shape, a urethane foam impregnated with each of these, and a thermal conductive foam containing a thermal conductor, are proposed (for example, Patent Literatures 1, 2).

### Citation List

### Patent Literature

- PTL1:: JP 2003-31980 A
- PTL2:: JP 2013-227486 A

### Summary of invention

### Technical Problem

The heat dissipation grease satisfactorily dissipates heat; however, it has a problem in that once it is applied, it is difficult to re-apply the grease, with the result that the production yield decreases. On the other hand, the heat dissipation gel has a problem in that it is generally difficult to process the gel into a sheet-like product having a thickness of 1 mm or less, and that, if compressed, the shape is deformed. In addition, the heat-dissipation gel has a problem in that if the thickness of the sheet reduces, compressive strength increases and flexibility decreases.

The thermal conductive foam also has a drawback as follows: Although the thermal conductive foam is preferably used for dissipating interior heat of thin electronic equipment to the exterior since it is thin and satisfactorily flexible, the thermal conductive foam is not adhesive itself, unlike silicone. Thus, an adhesive layer must be attached to the foam. However, if the adhesive layer is once attached to the surface of the foam, the foam is easily torn at the time of reworking since the foam is soft and thin.

The present invention was made in view of the above problems of conventional products and is directed to providing a thermal conductive laminate for electronic equipment having sufficient thinness, flexibility and thermal conductivity suitably used in the interior of electronic equipment as well as showing excellent workability, i.e., tear-proofness, at the time of reworking.

### Solution to Problem

The main subject of the present invention is a thermal conductive laminate for electronic equipment produced by attaching a two-sided adhesive tape to at least one surface of a foam sheet having a 25% compressive strength of 200 kPa or less and a thickness of 0.05 to 1.0 mm, in which the two-sided adhesive tape has a substrate formed of polyethylene terephthalate having a thickness of 2 to 100 µm.

### Advantageous Effects of Invention

According to this invention, it is possible to provide a thermal conductive laminate for electronic equipment having sufficient thinness, flexibility and thermal conductivity suitably used in the interior of electronic equipment and showing excellent workability, i.e., tear-proofness, at the time of reworking.

### Brief Description of Drawing

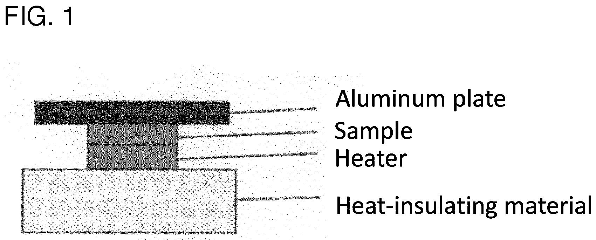

[Fig. 1] Fig. 1 is a view showing a laminate structure for measuring heat dissipation performance of thermal conductive laminates for electronic equipment formed in Examples and Comparative Examples.

### Description of Embodiments

The thermal conductive laminate for electronic equipment of the present invention is a thermal conductive laminate for electronic equipment produced by attaching a two-sided adhesive tape to at least one surface of a foam sheet having a 25% compressive strength of 200 kPa or less and a thickness of 0.05 to 1.0 mm, in which the two-sided adhesive tape has a substrate formed of polyethylene terephthalate having a thickness of 2 to 100 µm.

### <Foam sheet>

The foam sheet to be used in the present invention has a 25% compressive strength of 200 kPa or less. It is not preferable that the compressive strength exceeds 200 kPa, because, if so, the flexibility of the foam sheet decreases. In view of the flexibility of the foam sheet, the 25% compressive strength of the foam sheet is preferably 5 kPa or more, more preferably 10 kPa or more, further preferably 15 kPa or more and further more preferably 20 kPa or more; and preferably 190 kPa or less, more preferably 180 kPa or less, further preferably 150 kPa or less, further more preferably 100 kPa or less, further more preferably 50 kPa or less and further more preferably 40 kPa or less.

In view of the flexibility of the foam sheet, the 25% compressive strength of the foam sheet is preferably 5 to 190 kPa, more preferably 10 to 190 kPa, more preferably 15 to 150 kPa and further preferably 20 to 100 kPa.

The foam sheet to be used in the present invention preferably has a 50% compressive strength of 200 kPa or less. If the 50% compressive strength of the foam sheet is 200 kPa or less, the foam sheet can be suitably used in thin electronic equipment such as mobile terminals. In view of flexibility improvement, the 50% compressive strength of the foam sheet is more preferably 150 kPa or less and further preferably 100 kPa or less.

The thickness of the foam sheet is 0.05 to 1 mm. If the thickness of the foam sheet is less than 0.05 mm, the foam sheet is easily torn; whereas, if the thickness exceeds 1 mm, it is difficult to use the foam sheet in the interior space of small electronic equipment. In view of the strength of the foam sheet, the thickness of the foam sheet is preferably 0.05 to 0.8 mm, more preferably 0.05 to 0.7 mm and further preferably 0.05 to 0.5 mm.

The thermal conductivity of the foam sheet is preferably 0.3 to 10 W/m·K, more preferably 0.4 to 2.0 W/m·K and further preferably 0.45 to 2.0 W/m·K. If the thermal conductivity of the foam sheet falls within the above range, it is possible to effectively dissipate the interior heat of electronic equipment to the exterior.

The expansion ratio of the foam sheet is preferably 1.5 to 6, more preferably 1.5 to 5, further preferably 1.5 to 4 and further more preferably 1.5 to 3.5. If the expansion ratio of the foam sheet falls within the above range, it is possible for the foam sheet to be not only thin but also flexible.

The apparent density of the foam sheet is preferably 0.3 to 1.5 g/cm³, more preferably 0.35 to 1.5 g/cm³, further preferably 0.4 to 1.5 g/cm³, further more preferably 0.4 to 1.4 g/cm³, further more preferably 0.5 to 1.4 g/cm³ and further more preferably 0.55 to 1.2 g/cm³. If the apparent density of the foam sheet falls within the above range, the foam sheet having a desired thickness, flexibility and thermal conductivity can be obtained.

### <Elastomer resin>

The foam sheet to be used in the present invention is obtained by foaming an elastomer resin.

Examples of the elastomer resin that can be used in the present invention include an acrylonitrile butadiene rubber, a liquid-state acrylonitrile butadiene rubber, an ethylene-propylene-diene rubber, a liquid-state ethylene-propylene-diene rubber, an ethylene-propylene rubber, a liquid-state ethylene-propylene rubber, a natural rubber, a polybutadiene rubber, a liquid-state polybutadiene rubber, a polyisoprene rubber, a liquid-state polyisoprene rubber, a styrene-butadiene block copolymer, a liquid-state styrene-butadiene block copolymer, a hydrogenated styrene-butadiene block copolymer, a liquid-state hydrogenated styrene-butadiene block copolymer, a hydrogenated styrene-butadiene-styrene block copolymer, a liquid-state hydrogenated styrene-butadiene-styrene block copolymer, a hydrogenated styrene-isoprene block copolymer, a liquid-state hydrogenated styrene-isoprene block copolymer, a hydrogenated styrene-isoprene-styrene block copolymer and a liquid-state hydrogenated styrene-isoprene-styrene block copolymer. Of these, an acrylonitrile butadiene rubber, a liquid-state acrylonitrile butadiene rubber, an ethylene-propylene-diene rubber and a liquid-state ethylene-propylene-diene rubber are preferable.

In view of flexibility improvement, the content of the liquid elastomer in an elastomer resin is preferably 10 mass% or more and more preferably 20 mass% or more; and preferably 90 mass% or less and more preferably 80 mass% or less.

### <Thermal conductor>

In the present invention, in view of thermal conductivity improvement, it is preferable that an elastomer resin constituting the foam sheet contains a thermal conductor.

Examples of the thermal conductor that can be used in the present invention include oxides such as aluminum oxide and magnesium oxide; nitrides such as boron nitride and aluminum nitride; carbon compounds such as graphite and graphene; and talc. Of these, at least one selected from the group consisting of oxides, nitrides and talc is preferable; at least one selected from the group consisting of oxides is more preferable; at least one selected from the group consisting of aluminum oxide and magnesium oxide is further preferable; and magnesium oxide is further more preferable. These may be used alone or in combination of two or more.

The thermal conductivity of the thermal conductor is preferably 5 W/m·K or more, and more preferably 20 W/m·K or more. If the thermal conductivity falls within the above range, the thermal conductivity of the resultant foam sheet will be sufficiently high.

The content of the thermal conductor relative to 100 parts by mass of the elastomer resin is preferably 100 to 500 parts by mass. If the content of the thermal conductor is 100 parts by mass or more, it is possible for the foam sheet to obtain sufficient thermal conductivity. If the content of the thermal conductor is 500 parts by mass or less, it is possible to prevent flexibility of the foam sheet from reducing. In view of thermal conductivity and flexibility of the foam sheet, the content of the thermal conductor relative to 100 parts by mass of the elastomer resin is preferably 120 to 480 parts by mass and more preferably 150 to 450 parts by mass.

### <Foaming agent>

The foam sheet of the present invention is preferably produced by mixing the elastomer resin and an foaming agent, and chemically expanding the elastomer resin containing an foaming agent.

As the foaming agent for chemically expanding the elastomer resin containing an foaming agent, a heat decomposition type foaming agent, which is decomposed with heat to generate a gas, is preferable. Examples of the heat decomposition type foaming agent include azodicarbonamide, benzenesulfonyl hydrazide, dinitrosopentamethylenetetramine, toluenesulfonyl hydrazide and 4,4-oxybis(benzenesulfonylhydrazide). These may be used alone or in combination of two or more.

The content of the foaming agent relative to 100 parts by mass of the elastomer resin is preferably 1 to 30 parts by mass, more preferably 3 to 25 parts by mass and further preferably 5 to 20 parts by mass. If the content of the foaming agent falls within the above range, a foam excellent in flexibility can be obtained.

### <Optional components>

In the present invention, if necessary, various types of additional components can be contained within the range where the objects of the present invention will not be damaged.

The types of additional components are not particularly limited and various additives that are usually used in expansion molding can be used. Examples of such additives include a lubricant, a shrinkage inhibitor, a foam nucleating agent, a nucleating agent for crystallization, a plasticizer, a coloring agent (e.g., pigment, dye), a UV absorbent, an antioxidant, an anti-aging agent, a filler excluding the aforementioned conductivity imparting material, a strengthening agent, a flame retardant, a flame retardant promoter, an antistatic agent, a surfactant, a vulcanizing agent and a surface treatment agent. The addition amounts of additives can be appropriately selected as long as formation of air foam is not damaged. The addition amounts of additives that are usually used for expansion and molding of a resin can be employed. These may be used alone or in combination of two or more.

The lubricant not only improves flowability of a resin but also suppresses deterioration of a resin by heat. The lubricant to be used in the present invention is not particularly limited as long as it effectively improves flowability of a resin. Example thereof include hydrocarbon lubricants such as liquid paraffin, paraffin wax, microwax and polyethylene wax; fatty acid lubricants such as stearic acid, behenic acid and 12-hydroxy stearic acid; and ester lubricants such as butyl stearate, stearic acid monoglyceride, pentaerythritol tetrastearate, hydrogenated castor oil and stearyl stearate.

The addition amount of the lubricant relative to 100 parts by mass of an elastomer resin is preferably about 0.01 to 5 parts by mass, more preferably 0.05 to 4 parts by mass and further preferably 0.1 to 3 parts by mass. If the addition amount exceeds 10 parts by mass, flowability becomes extremely high, with the result that the expansion ratio may decrease. In contrast, if the addition amount is less than 0.5 parts by mass, flowability cannot be improved and stretchability during foam formation decreases, with the result that the expansion ratio may decrease.

Examples of the flame retardant include, other than metal hydroxides such as aluminum hydroxide and magnesium hydroxide, bromine-based flame retardants such as decabromodiphenyl ether and phosphorus-based flame retardants such as ammonium polyphosphate.

Examples of the flame retardant promoter include antimony compounds such as antimony trioxide, antimony tetraoxide, antimony pentoxide, sodium pyroantimonate, antimony trichloride, antimony trisulfide, antimony oxychloride, antimony dichloride perchloropentane and potassium antimonate; boron compounds such as zinc metaborate, zinc tetraborate, zinc borate and basic zinc borate; zirconium oxides; tin oxides; and molybdenum oxides.

### <Method for producing foam sheet>

The foam sheet to be used in the present invention can be produced by a chemical foaming method or a physical foaming method known in the art. The method for producing the sheet is not particularly limited.

Note that, as a foam-processing method, methods known in the art including those described in Plastic Foam Handbook (edited by Hiroshi Maki and Atsushi Osakada, published by NIKKAN KOGYO SHIMBUN, LTD., 1973) can be used.

### <Two-sided adhesive tape>

The thermal conductive laminate for electronic equipment of the present invention is produced by attaching a two-sided adhesive tape to at least one surface of the foam sheet and the substrate of the two-sided adhesive tape is constituted of polyethylene terephthalate having a thickness of 2 to 100 µm.

If the thickness of the substrate of the two-sided adhesive tape is less than 2 µm, the substrate is easily torn and workability of a laminate deteriorates. The thickness of the substrate of the two-sided adhesive tape is preferably 3 to 100 µm, more preferably 3 to 80 µm and further preferably 4 to 50 µm, in view of the workability of a laminate. If the thickness of the substrate is 100 µm or less, heat dissipation performance improves, and further, the total thickness is reduced, and thus, the laminate can be easily used in the interior spaces of small electronics.

In the present invention, since polyethylene terephthalate (hereinafter referred to as "PET") is used as the substrate, thermal conductive laminate for electronic equipment having excellent workability, i.e., tear-proofness, at the time of reworking.

In the present invention, the total thickness of the two-sided adhesive tape, in other words, the total thickness of the substrate and the adhesive layer, is preferably 5 to 150 µm, more preferably 6 to 120 µm and further preferably 7 to 110 µm. If the total thickness of the two-sided adhesive tape falls within the above range, heat dissipation performance improves and the laminate can be easily used in the interior spaces of small electronics.

The two-sided adhesive tape is not particularly limited as long as it has a substrate having the thickness as mentioned above. For example, "3801X (the thickness of a PET substrate: 4 µm)", "3805H (the thickness of a PET substrate: 40 µm)" and "3810H (the thickness of a PET substrate: 50 µm)" manufactured by SEKISUI CHEMICAL CO., LTD., can be preferably used.

### <Method for producing a thermal conductive laminate for electronic equipment>

A method for producing the thermal conductive laminate for electronic equipment of the present invention is not particularly limited and the laminate can be produced by a general method. For example, a method of laminating a foam sheet and a two-sided adhesive tape can be mentioned. Note that they may be laminated at room temperature under the atmospheric pressure or while heating under pressure.

### Examples

The present invention will be more specifically described by way of Examples; however, the present invention is not limited by these Examples.

The materials used in the following Production Examples are as follows.
(1) Ethylene-propylene-diene rubber (EPDM)
   Trade name "EP21", manufactured by JSR Corporation,
   Density: 0.86 g/cm³
   Content of propylene: 34 mass%
(2) Liquid ethylene-propylene-diene rubber (liquid-state EPDM) Trade name "PX-068", manufactured by Mitsui Chemicals, Inc.
   Density: 0.9 g/cm³
   Content of propylene: 39 mass%

(3) Azodicarbonamide Trade name "SO-L", manufactured by Otsuka Chemical Co., Ltd.
(4) Magnesium oxide
   Trade name "RF-10C-SC", manufactured by Ube Material Industries Pulverized product, 45 µm or less, sieved average particle size: 4 µm Thermal conductivity: 42 to 60 W/m·K
(5) Phenol oxidant
   Trade name "IRGANOX1010", manufactured by BASF Japan Ltd.

### [Production Example 1]

180 g of a mixture containing 60 parts by mass of an ethylene-propylene-diene rubber, 40 parts by mass of a liquid-state ethylene-propylene-diene rubber, 17 parts by mass of azodicarbonamide, 360 parts by mass of magnesium oxide and 0.1 parts by mass of a phenol oxidant was melt-kneaded and then pressed to obtain an expandable resin sheet having a thickness of 0.4 mm. To both surfaces of the obtained expandable resin sheet, 3.0 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.60 g/cm³ and a thickness of 0.5 mm.

### [Production Example 2]

180 g of a mixture containing 50 parts by mass of an ethylene-propylene-diene rubber, 50 parts by mass of liquid-state ethylene-propylene-diene rubber, 20 parts by mass of azodicarbonamide, 300 parts by mass of magnesium oxide and 0.1 part by mass of a phenolic antioxidant was melt-kneaded and then pressed to obtain an expandable resin sheet having a thickness of 0.32 mm. To both surfaces of the obtained expandable resin sheet, 3.0 Mrad of an electron beam was applied at an acceleration voltage of 500 keV to crosslink the expandable resin sheet. Subsequently, the sheet was heated to 250°C to expand the expandable resin sheet to obtain a foam sheet having an apparent density of 0.35 g/cm³ and a thickness of 0.5 mm.

### Example 1

One of the surfaces of the foam sheet obtained in Production Example 1, a two-sided adhesive tape ["3801X" (the thickness of a PET substrate: 4 µm, the total thickness of the two-sided adhesive tape: 10 µm) manufactured by SEKISUI CHEMICAL CO., LTD.] was attached to obtain a thermal conductive laminate for electronic equipment.

### Example 2

The same operation as in Example 1 was repeated except that the two-sided adhesive tape to be attached was changed to "3805H" (the thickness of a PET substrate: 40 µm, the total thickness of the two-sided adhesive tape: 50 µm) manufactured by SEKISUI CHEMICAL CO., LTD.

### Example 3

The same operation as in Example 1 was repeated except that the two-sided adhesive tape to be attached was changed to "3810H" (the thickness of a PET substrate: 50 µm, the total thickness of the two-sided adhesive tape: 100 µm) manufactured by SEKISUI CHEMICAL CO., LTD.

### Example 4

The same operation as in Example 1 was repeated except that the foam sheet obtained in Production Example 2 was used.

### Example 5

The same operation as in Example 3 was repeated except that the foam sheet obtained in Production Example 2 was used.

### Comparative Example 1

To the foam sheet obtained in Production Example 1, an acrylic adhesive was applied to a thickness of 20 µm to obtain a foam sheet attached with an adhesive layer.

### Comparative Example 2

To the foam sheet obtained in Production Example 1, a two-sided tape having a nonwoven substrate ["#5782" (the thickness of a nonwoven substrate: 70 µm, the total thickness of the two-sided tape having a nonwoven substrate: 130 µm) manufactured by SEKISUI CHEMICAL CO., LTD.] was attached to obtain a laminate.

### Comparative Example 3

To one of the surfaces of the foam sheet obtained in Production Example 1, a two-sided adhesive tape ["3820BH " (the thickness of a PET substrate: 130 µm, the total thickness of the two-sided adhesive tape: 200 µm) manufactured by SEKISUI CHEMICAL CO., LTD.] was attached to obtain a laminate.

### <Physical properties>

Physical properties of the obtained foam sheets were measured as follows. The measurement results of individual properties are shown in Table 1.

### [Expansion ratio]

The expansion ratio was calculated by dividing the specific gravity of a foam sheet by the specific gravity of an expandable resin sheet.

### [Apparent density]

Apparent density was measured in accordance with JIS K 7222.

### [25% compressive strength]

The 25% compressive strength of a foam sheet in the thickness direction was measured in accordance with JIS K6767-7.2.3 (JIS2009).

### [Thermal conductivity of foam sheet]

The thermal conductivity of an unfoamed resin sheet was measured at 25°C by "TC-7000" manufactured by ULVAC-RIKO, Inc., in accordance with a laser flash method, and thereafter, thermal conductivity of foam sheet was computationally obtained as a calculation value based on the following expression and the apparent density.
1/λₑ = {(1-V^{1/3}))/λ_{S}} + V^{1/3}/{λ_{S}·(1-V^{2/3}) + λ_{g}·V^{2/3}}
λₑ: denotes the thermal conductivity of foam sheet
V: denotes the porosity of foam sheet (porosity = 1-[1/expansion ratio])
λ_{S}: denotes the thermal conductivity of unfoamed resin sheet
λ_{g}: denotes the thermal conductivity of air

### [Maximum tensile strength]

The maximum tensile strength of laminates obtained in Examples and Comparative Examples was measured by using a tensile tester in accordance with JIS K6767 (Method A).

### [Thermoconductive performance]

The thermoconductive performance of each of the sheets obtained in Examples and Comparative Examples was measured using a laminate structure shown in Fig. 1. Specifically, a heater (microceramic heater, model number "MS5", manufactured by SAKAGUCHI E.H. VOC. CORP.) of 25 mm x 25 mm x 2 mm was put on a heat-insulating material. On the heater, a sample of 25 mm x 25 mm produced in each of Examples and Comparative Examples was laid. On the sample, an aluminum plate of 50 mm x 100 mm x 2 mm was put. In this manner, a structure for dispersing heat transmitted through the sample in the aluminum plate was formed. In this state, an electric power of 1 W was applied to the heater. In 15 minutes when the temperature of the heater reached a constant value, the temperature [T] (°C) of the heater was measured. It is shown that the thermoconductive performance is better as the value is smaller.

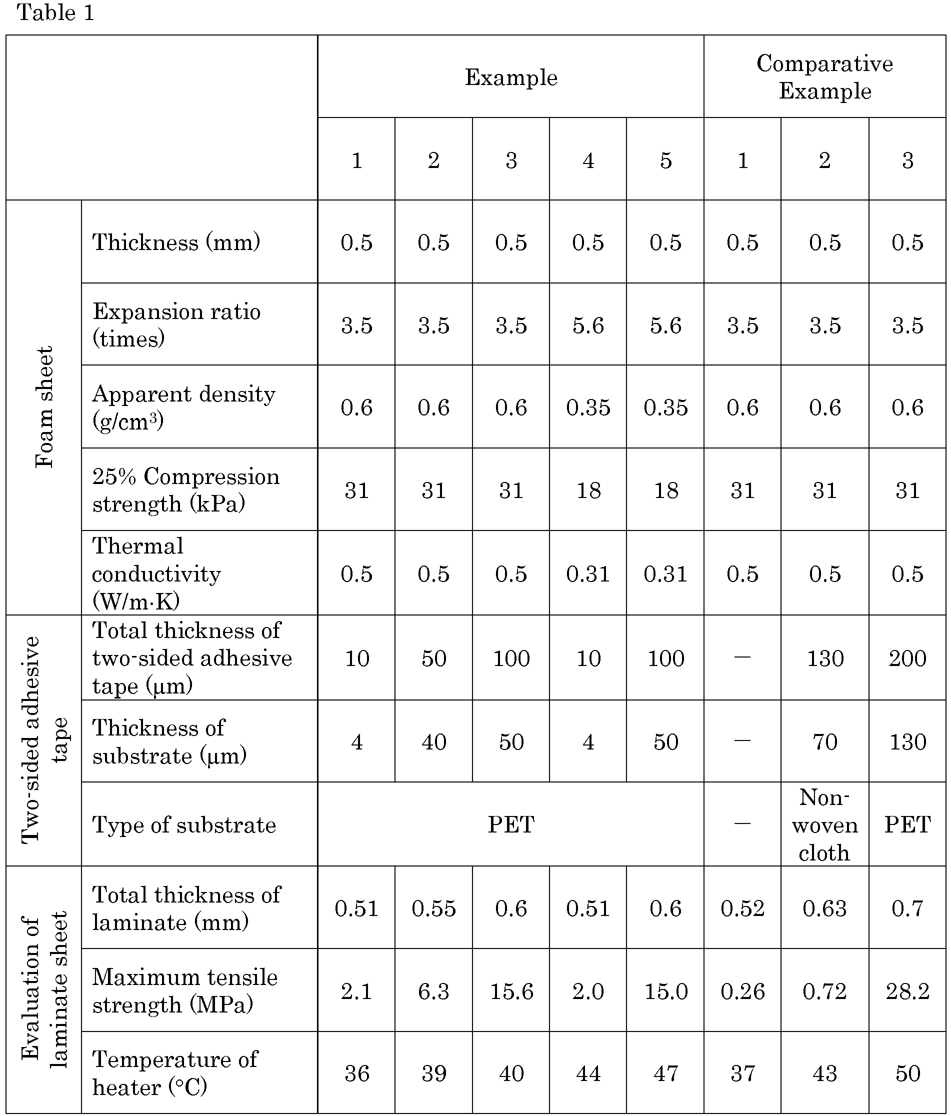

From the results of Examples and Comparative Examples, it is found that the thermal conductive laminate for electronic equipment of the present invention has thinness, flexibility and thermal conductivity and excellent workability.

## Claims

1. A thermal conductive laminate for electronic equipment produced by attaching a two-sided adhesive tape to at least one surface of a foam sheet having a 25% compressive strength of 200 kPa or less and a thickness of 0.05 to 1.0 mm, wherein the two-sided adhesive tape has a substrate formed of polyethylene terephthalate having a thickness of 2 to 100 µm.

2. The thermal conductive laminate for electronic equipment according to claim 1, wherein the elastomer resin constituting the foam sheet contains at least one a thermal conductor selected from oxides, nitrides and talc.

3. The thermal conductive laminate for electronic equipment according to claim 2, wherein the content of the thermal conductor relative to 100 parts by mass of the elastomer resin is 100 to 500 parts by mass.

4. The thermal conductive laminate for electronic equipment according to any one of claims 1 to 3, wherein the expansion ratio of the foam sheet is 1.5 to 6.

5. The thermal conductive laminate for electronic equipment according to any one of claims 1 to 4, wherein the substrate of the two-sided adhesive tape has a thickness of 3 to 100 µm.
